# EUROPEAN PATENT APPLICATION

(11) **EP 2 003 938 A2**
(43) Date of publication of application: **17.12.2008**
(21) Application number: 08152252.6
(22) Date of filing: 04.03.2008
(51) Int. Cl.: H05K 1/18

(54) **Printed-circuit board of an improved type for an electronic device**

(30) Priority: 05.03.2007 IT BO20070150
(71) Applicant: Elettronica Biesse S.r.l., 40041 Gaggio Montano (BO) (IT)
(72) Inventor: Ceccaroli, Stefano, 40041 Gaggio Montano (IT)
(74) Representative: Jorio, Paolo

(57) **Abstract**

In an electronic device (1) provided with electronic components (3) and one or more button batteries (5, 6) for the electrical supply of the electronic components (3), a printed-circuit board (2), which provides a support and electrical connection for said electronic components (3), has a plane insulating support (7) having an opening (9), which receives and withholds the batteries (5, 6) in a position transverse to the insulating support (7) itself and is defined by an internal edge (19) of the insulating support (7), there being provided on the internal edge (19) a first electrical contact (20, 22; 20b, 22b) for the positive pole (5c) of the batteries (5, 6) and a second electrical contact (21) for the negative pole (5b; 6b) of the batteries (5, 6).

## Description

The present invention relates to a printed-circuit board of an improved type for an electronic device.

Any type of electronic device incorporates at least one printed-circuit board, which comprises, in general, a support made of insulating material, on which the electronic components of the device are mounted, and a printed circuit constituted by conductive paths printed on the insulating support for connecting the electronic components electrically to one another so as to provide a particular electronic function.

The simplest electronic devices, mounted on objects of small dimensions and functioning without the aid of the electrical mains supply, typically comprise a single printed-circuit board, mounted on which are one or more button batteries, which have longitudinal dimensions, i.e. a thickness, smaller than the transverse dimensions, i.e. the diameter. A button battery comprises a metal bottom, which functions as negative pole, and a cover, which is also made of metal and functions as positive pole, and is usually secured to the printed circuit via a battery holder comprising a metal elastic element, for example, a tab or a spring, which, functioning as contact for the positive pole, presses the battery on the insulating support with the negative pole set corresponding to a respective contact provided on the support itself.

In particularly simple electronic boards, the dimensions of the printed-circuit board necessary for mounting and connecting only the electronic components are often smaller than the transverse dimensions of the battery. Consequently, the extension of the printed-circuit board is substantially conditioned by the diameter of the battery and by the presence of the battery holder. When said printed-circuit boards are to be housed in objects that must have extremely small outer dimensions, the button battery and the corresponding battery holder are rather cumbersome. In addition, the use of a battery holder in circuit boards with a limited number of components increases the cost of said electronic boards considerably.

The aim of the present invention is to provide a printed-circuit board equipped with one or more button batteries for an electronic device, said printed-circuit board being extremely compact and, at the same time, being easy and inexpensive to produce.

According to the present invention, a printed-circuit board for an electronic device and an electronic device are provided according to what is defined in the annexed claims.

The present invention will now be described with reference to the annexed drawings, which illustrate a non-limiting example of embodiment thereof and in which:
- Figure 1 illustrates, according to a top plan view, an electronic device provided with a pair of button batteries and a printed-circuit board according to the present invention;
- Figure 2 illustrates in greater detail the printed-circuit board of Figure 1 without electronic components; and
- Figures 3 and 4 illustrate further embodiments of the printed-circuit board of Figure 2.

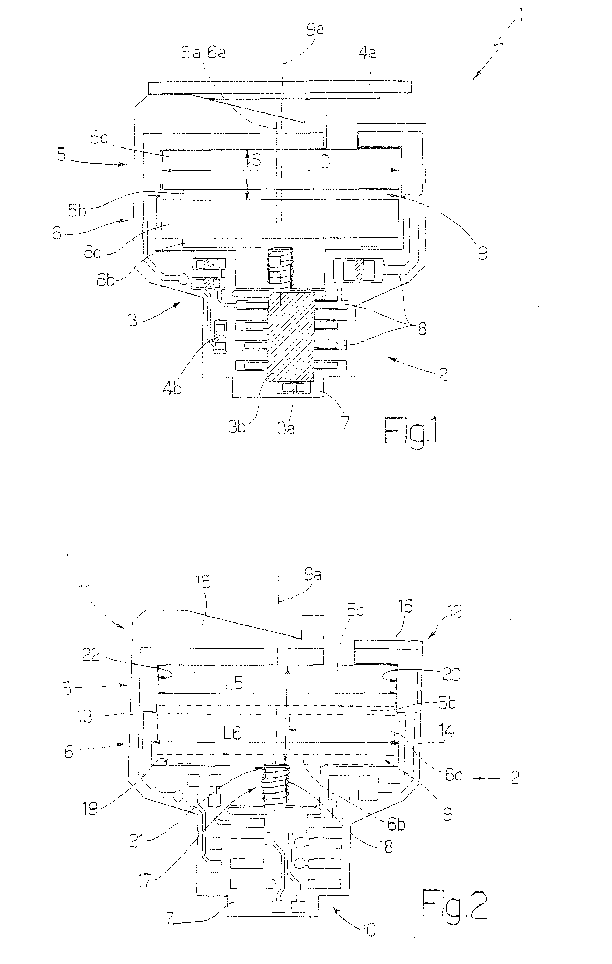

In Figure 1, designated as a whole by 1 is an electronic device, which performs a particular function of acoustic and/or visual warning to signal that a given temperature of a fluid has been reached. The electronic device 1 comprises: a printed-circuit board 2 provided according to the present invention; a plurality of electronic components 3, amongst which a temperature sensor 3a and a microcontroller 3b; an acoustic warning device 4a, of the type with piezoelectric lamina, and a visual warning device 4b, of the LED type; and two identical button batteries 5 and 6 for the electrical supply of the components 3, 4a and 4b.

Each battery 5, 6 is of a known type, for example, of the CR1632 type, presenting a longitudinal axis 5a, 6a, an outer diameter D, a thickness S and comprising a metal bottom, which defines the negative pole 5b, 6b, and a metal cover, which defines the positive pole 5c, 6c.

The printed-circuit board 2 comprises: a plane insulating support 7, designed to support the components 3, 4a and 4b; and a printed circuit, provided with a plurality of conductive paths 8, and in particular metal paths, printed on the top face and bottom face (not illustrated) of the insulating support 7 for connecting electrically the components 3, 4a and 4b and the batteries 5 and 6 according to a given electronic function. The insulating support 7 comprises an opening 9 presenting an axis 9a of longitudinal symmetry and designed to receive, in a position transverse to the insulating support 7 itself, the two batteries 5 and 6 set up against one another with their respective axes 5a and 6a substantially parallel to the insulating support 7 and to the axis 9a. The batteries 5 and 6 are set up against one another with the negative pole 5b in contact with the positive pole 6c so as to be connected electrically in series.

According to what is illustrated in Figure 2, where the printed-circuit board 2 is shown without the electronic components 3, the acoustic and visual warning devices 4a and 4b, and the batteries 5 and 6, which are in any case illustrated for reasons of clarity in their position with a dashed line, the insulating support 7 comprises a main body 10, mounted on which are the electronic components 3, and two appendages 11, 12, extending from the main body 10 and L-shaped so as to surround, together with the main body 10, the opening 9 almost completely. The appendages 11, 12 are elastically deformable and define, in use, two jaws of a clamp designed to withhold at least the battery 5 in a transverse direction by pressure. In greater detail, the appendages 11 and 12 comprise respective side portions 13 and 14, which extend from the main body 10 in a direction parallel to one another in such a way that they are set at the same distance from the axis 9a and are designed to press on respective opposite side portions (not illustrated) of the battery 5 so as to withhold it in a transverse direction. The appendages 11 and 12 further comprise respective end portions 15 and 16 facing one another, which form, with the respective side portions 13 and 14, respective angles that are substantially right angles to define an axial rest for the battery 5.

The insulating support 7 further comprises a third appendage 17, which extends from the main body 10 in a direction parallel to the axis 9a of symmetry of the opening 9. Applied on the appendage 17 is a conductive elastic element 18, which is constituted by a metal helical spring partially wound around the appendage 17 itself and is designed to press the battery 6 axially against the battery 5 in the direction of the axis 9a, whilst the battery 5 rests on the end portions 15 and 16.

The opening 9 is defined by an internal edge 19 of the insulating support 7, which develops along the appendages 11 and 12, passing through the main body 10 around the appendage 17. A first stretch 20 of the internal edge 19 developing along the appendage 12, and in particular between the side portion 14 and the end portion 16, is metallized to define a contact for the positive pole 5c of the battery 5. A second stretch 21 of the internal edge 19 developing around the appendage 17 is metallized and electrically in contact with the elastic element 18 so as to define a contact for the negative pole 6b of the battery 6. A third stretch 22 of the internal edge 19 developing along the appendage 11, and in particular between the side portion 13 and the end portion 15 is metallized to define a further contact for the positive pole 5c of the battery 5 and thus increase the overall surface of electrical contact for the positive pole 5c. The first stretch 20 and the second stretch 22 are connected together via a path (not illustrated) provided on a rear face (not illustrated) of the insulating support 7.

The internal edge 19 along the side portions 13 and 14 is shaped so as to define two housing positions, one for each battery 5, 6, corresponding to which the opening 9 has two different widths L5 and L6, each measured in a direction orthogonal to the axis 9a and in the absence of the respective battery 5, 6. In particular, the width L5 is slightly smaller than the diameter D of the battery 5, 6 to enable said clamp to withhold the battery 5 by pressure, and the width L6 is slightly greater than the diameter D to define a transverse play between the opening 9 and the battery 6 such as not to hinder the action of the elastic element 18, and hence guarantee contact between the negative pole 5b and the positive pole 6c.

In addition, the opening 9 has a minimum length L, defined along the axis 9a between the end portion 15 and the appendage 17, greater than twice the thickness S of the battery 5, 6 so as to facilitate insertion of the batteries 5 and 6 in the opening 9 itself during assembly of the electronic board 1.

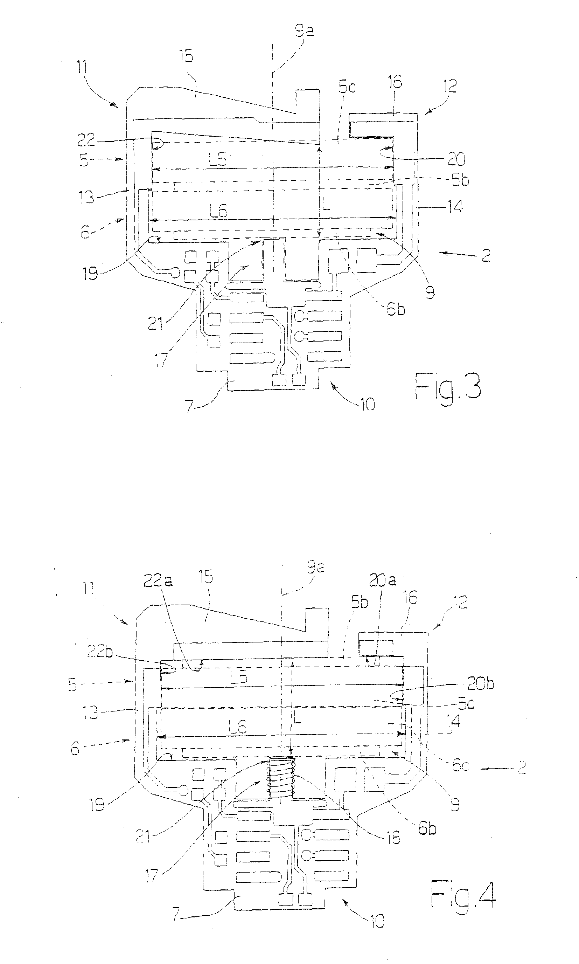

In a second embodiment of the present invention illustrated in Figure 3, the printed-circuit board 2 does not envisage the use of the elastic element 18 illustrated in Figure 2 for pressing the batteries 5 and 6 against one another. In its place, an appendage 11 is provided according to a conformation different from the one illustrated in Figure 2, as described hereinafter. In fact, the end portion 15 of the appendage 11 forms, with the corresponding side portion 13, an acute angle so as to reduce the length L of the opening 9 to a value smaller than twice the thickness S such that, when the clamp formed by the appendages 11 and 12 withholds at least the battery 5 in a transverse direction by pressure, the end portion 15 will press the battery 5 axially against the battery 6, whilst the latter rests on the appendage 17.

According to a third embodiment (not illustrated) of the present invention, the printed-circuit board 2 comprises both the elastic element 18 illustrated in Figures 1 and 2 and the appendage 11 illustrated in Figure 3. In this case, the end portion 15 co-operates with the elastic element 18 so as to press the batteries 5 and 6 against one another.

In a fourth embodiment illustrated in Figure 4 and substantially deriving from the embodiment illustrated in Figure 2, the batteries 5 and 6 are connected in parallel with their respective positive poles 5c and 6c in contact with one another. To enable this characteristic, the printed-circuit board 2 of Figure 4 differs from that of Figure 2 in that the internal edge 19 has, instead of the stretch 20 of Figure 2, a stretch 20a that develops along the end portion 16 and is metallized to define a contact for the negative pole 5b of the battery 5, and another stretch 20b that develops along the side portion 14 and is metallized to define a contact for the positive pole 5c of the battery 5. In addition, the internal edge 19 has, instead of the stretch 22 of Figure 2, a stretch 22a that develops along the end portion 15 and is metallized to define a further contact for the negative pole 5b of the battery 5, and another stretch 22b that develops along the side portion 13 and is metallized to define a further contact for the positive pole 5c of the battery 5. In addition, the stretch 21 is short-circuited with the stretch 20a via a path (not illustrated) provided on a rear face (not illustrated) of the insulating support 7.

According to a fifth embodiment (not illustrated), the printed-circuit board 2 is configured for connection in parallel of the batteries 5 and 6 as illustrated in Figure 4, but does not envisage the use of the elastic element 18 for pressing the batteries 5 and 6 against one another. Instead, an appendage 11 is provided, set at an acute angle according to what is illustrated in Figure 3.

In a sixth embodiment not illustrated and substantially deriving from the embodiment illustrated in Figure 2, the appendages 11 and 12 are joined in a position corresponding to the respective end portions 15 and 16 to form a single U-shaped body that completely surrounds, together with the main body 10, the opening 9 in such a way that the internal edge 19 that defines the opening 9 itself is continuous. The batteries 5 and 6 are withheld in the opening 9 via the action of the elastic element 18 applied on the appendage 17, which presses the batteries 5 and 6 axially towards a stretch of the internal edge 19 extending along the U-shaped body in a way substantially perpendicular to the axis 9a.

From the above description, it is clear that the principle of construction of the printed-circuit board 2 does not change in the case of use of just one battery or else of more than two batteries set in series or in parallel to one another, in so far as it is simply necessary to size the opening 9 along the axis 9a, i.e., vary the length L, as a function of the overall thickness given by the number of batteries to be housed.

In particular, in embodiments (not illustrated) that envisage just the battery 5, the elastic element 18 presses the battery 5 directly on the end portions 15 and 16, or else, in the version without the elastic element 18, the end portion 15 presses the battery 5 directly on the appendage 17 that extends from the main body 10.

In addition, in an embodiment (not illustrated) that envisages more than two batteries, the width of the opening 9 must be equal to L6, i.e., must comprise said transverse play, in regions corresponding to the housing positions of all the batteries except the first battery 5.

The main advantage of the present invention is that it provides a self-supplied printed-circuit board 2 that presents extremely contained dimensions, and that it is inexpensive and simple to assemble thanks to the absence of any battery holders, the presence of which would, instead, require considerable space on the insulating support 7, as well as more complex steps of assembly.

## Claims

1. A printed-circuit board for an electronic device (1) comprising electronic components (3) and at least one button battery (5, 6) for the electrical supply of the electronic components (3); the printed-circuit board (2) comprising a plane insulating support (7) for supporting the electronic components (3); and being **characterized in that** the insulating support (7) comprises at least one opening (9) designed to receive and withhold, in a position transverse to the insulating support (7) itself, said at least one battery (5, 6) .

2. The printed-circuit board according to Claim 1, wherein said insulating support (7) comprises a first body (10) and a second body, which is U-shaped and, together with the first body (10), surrounds the opening (9) completely.

3. The printed-circuit board according to Claim 2, comprising elastic means (18) mounted on said first body (10) so as to press said at least one battery (5; 6) axially towards an internal edge of said second body.

4. The printed-circuit board according to Claim 1, wherein said insulating support (7) comprises a main body (10), and two appendages (11, 12) extending from the main body (10) so as to surround said opening (9) partially.

5. The printed-circuit board according to Claim 4, wherein each of the appendages (11, 12) is L-shaped.

6. The printed-circuit board according to Claim 4 or Claim 5, wherein each of the appendages (11, 12) is elastically deformable and defines, in use, a respective jaw of a clamp designed to withhold said at least one battery (5, 6) by pressure in a transverse direction.

7. The printed-circuit board according to Claim 6, wherein at least a first one (11) of the appendages (11, 12) comprises an end portion (15) designed, when said clamp withholds said at least one battery (5, 6) in a transverse direction, to press the battery (5, 6) itself axially towards said main body (10).

8. The printed-circuit board according to any one of Claims 4 to 7, wherein each of the appendages (11, 12) comprises a respective end portion (15, 16); the printed circuit (2) comprising elastic means (18) mounted on said main body (10) so as to press said at least one battery (5; 6) axially towards the end portions (15, 16).

9. The printed-circuit board according to Claim 8, wherein said electronic device (1) comprises a first button battery (5) and at least one second button battery (6); said clamp being designed to withhold at least the first battery (5) in a transverse direction by pressure.

10. The printed-circuit board according to Claim 9, wherein at least a first one (11) of the appendages (11, 12) comprises an end portion (15) designed, when said clamp withholds the first battery (5) in a transverse direction, to press the first battery (5) itself axially against said second battery (6), whilst the latter rests on said main body (10).

11. The printed-circuit board according to Claim 9 or Claim 10, wherein said appendages (11, 12) comprise respective end portions (15, 16), which define an axial rest for said first battery (5); the printed circuit (2) comprising elastic means (18) designed to press the second battery (6) axially against the first battery (5).

12. The printed-circuit board according to any one of Claims 8 to 11, wherein said opening (9) has an axis of symmetry (9a) and said insulating support (7) comprises a third appendage (17) extending from said main body (10) in a direction parallel to said axis of symmetry (9a); said elastic means comprising a helical spring (18) partially wound around the third appendage (17).

13. The printed-circuit board according to any one of Claims 1 to 12, wherein said at least one battery (5, 6) comprises a positive pole (5c, 6c) and a negative pole (5b, 6b); said insulating support (7) comprising an internal edge (19), which defines said opening (9) and provided on which are a first electrical contact (20, 22; 20b, 22b) for the positive pole (5c) and a second electrical contact (21) for the negative pole (5b; 6b).

14. The printed-circuit board according to Claim 13, wherein said electronic device (1) comprises a first button battery (5) and at least one second button battery (6) presenting respective positive poles (5c, 6c) and negative poles (5b, 6b); said first electrical contact (20, 22; 20b, 22b) being for the positive pole (5c) of the first battery (5) and said second electrical contact (21) being for the negative pole (6b) of the second battery (6).

15. The printed-circuit board according to Claim 14, wherein said first battery (5) and said at least one second battery (6) are connected to one another in series.

16. The printed-circuit board according to Claim 14, wherein said first battery (5) and said at least one second battery (6) are connected to one another in parallel.

17. The printed-circuit board according to Claim 16, wherein provided on said internal edge (19) is a third electrical contact (20a, 22a) for the negative pole (5b) of said first battery (5).

18. The printed-circuit board according to any one of Claims 13 to 17, wherein said insulating support (7) comprises a main body (10), and two appendages (11, 12) extending from the main body (10) so as to surround said opening (9) partially; said internal edge (19) comprising: a first stretch (22, 20; 22b, 20b), which develops along at least one of said appendages (11, 12) and on which said first electrical contact is provided; and a second stretch (21), which develops along a portion (17) of said main body (10) and on which said second electrical contact is provided.

19. The printed-circuit board according to Claim 17, wherein said insulating support (7) comprises a main body (10), and two appendages (11, 12) extending from the main body (10) so as to surround said opening (9) partially; each appendage (11, 12) comprising a respective end portion (15, 16) and a respective side portion (13, 14) extending between the main body (10) and the end portion (15, 16); said internal edge (19) comprising: a first stretch (22b, 20b), which develops along at least one of the side portions (13, 14) and on which said first electrical contact is provided; a second stretch (21), which develops along a portion (17) of said main body (10) and on which said second electrical contact is provided; and a third edge stretch (22a, 20a), which develops along at least one of the end portions (15, 16) and on which said third electrical contact is provided.

20. The printed-circuit board according to any one of Claims 13 to 19, wherein said insulating support (7) comprises a main body (10), and two appendages (11, 12) extending from the main body (10) so as to surround said opening (9) partially; each appendage (11, 12) comprising a respective end portion (15, 16); the printed circuit (2) comprising elastic means (18) mounted on said main body (10), which are designed to press said at least one battery (5; 6) axially towards the end portions (15, 16) and are electrically in contact with said second electrical contact (21).

21. An electronic device, comprising: electronic components (3); at least one button battery (5, 6) for electrical supply of the electronic components (3); and a printed-circuit board (2) for supporting and connecting the electronic components (3) electrically; the device (1) being **characterized in that** the printed-circuit board (2) is of the type claimed in any one of Claims 1 to 20.
